# FASCICULE DE BREVET EUROPEEN

(11) **EP 3 953 770 B1**
(45) Date de publication et mention de la délivrance du brevet: **26.04.2023**
(21) Numéro de dépôt: 20713332.3
(22) Date de dépôt: 30.03.2020
(51) Int. Cl.: G04F 5/14

(54) **MICRO-HORLOGE ATOMIQUE DU TYPE FONCTIONNANT DANS UN REGIME IMPULSIONNEL**
MINIATUR-ATOMUHR MIT PULSMODUSBETRIEB
MINIATURE ATOMIC CLOCK WITH PULSE MODE OPERATION

(30) Priorité: 08.04.2019 FR 1903687
(43) Date de publication de la demande: 16.02.2022
(73) Titulaire: Syrlinks, 35510 Cesson Sévigné (FR)
(72) Inventeur: DANET, Jean-Marie, 35700 Rennes (FR); BROUCQUART, Romain, 35510 Cesson Sévigné (FR)
(74) Mandataire: Vidon Brevets & Stratégie
(86) Numéro de dépôt international: PCT/EP2020/058914
(87) Numéro de publication internationale: WO 2020/207837

(56) Documents cités:
- WARREN Z ET AL: "Pulsed coherent population trapping with repeated queries for producing single-peaked high contrast Ramsey interference", JOURNAL OF APPLIED PHYSICS, AMERICAN INSTITUTE OF PHYSICS, US, vol. 123, no. 5, 6 février 2018 (2018-02-06), XP012226150, ISSN: 0021-8979, DOI: 10.1063/1.5008402 [extrait le 2018-02-06]
- ABDEL HAFIZ M ET AL: "Symmetric autobalanced Ramsey interrogation for high-performance coherent-population-trapping vapor-cell atomic clock", APPLIED PHYSICS LETTERS, A I P PUBLISHING LLC, US, vol. 112, no. 24, 13 juin 2018 (2018-06-13), XP012229193, ISSN: 0003-6951, DOI: 10.1063/1.5030009 [extrait le 2018-06-13] cité dans la demande
- C. SANNER, N. HUNTENMANN, R. LANGE, CHR. TAMM, E. PEIK: "Autobalanced Ramsey Spectroscopy", PHYSICAL REVIEW LETTERS, vol. 120, 053602, 30 janvier 2018 (2018-01-30), XP002795476,
- SUN X L ET AL: "Suppression of Dick Effect in the Ramsey-CPT atomic clock by Interleaving Lock", ARXIV.ORG, CORNELL UNIVERSITY LIBRARY, 201 OLIN LIBRARY CORNELL UNIVERSITY ITHACA, NY 14853, 6 juillet 2017 (2017-07-06), XP080779056,
- SINDA MEJRI ET AL: "Atomic clock using coherent population trapping in a cesium cell: frequency stability and limitations", JOURNAL OF PHYSICS: CONFERENCE SERIES, INSTITUTE OF PHYSICS PUBLISHING, BRISTOL, GB, vol. 723, no. 1, 4 juillet 2016 (2016-07-04), page 12014, XP020304817, ISSN: 1742-6596, DOI: 10.1088/1742-6596/723/1/012014 [extrait le 2016-07-04]
- SHUKER M ET AL: "Reduction of light shifts in Ramsey spectroscopy with a combined error signal", ARXIV.ORG, CORNELL UNIVERSITY LIBRARY, 201 OLIN LIBRARY CORNELL UNIVERSITY ITHACA, NY 14853, 1 mars 2019 (2019-03-01), XP081122211,
- DANET JEAN-MARIE ET AL: "Dick effect in a pulsed atomic clock using coherent population trapping", IEEE TRANSACTIONS ON ULTRASONICS, FERROELECTRICS AND FREQUENCY CONTROL, IEEE, US, vol. 61, no. 4, 1 avril 2014 (2014-04-01), pages 567-574, XP011549631, ISSN: 0885-3010, DOI: 10.1109/TUFFC.2014.2945 [extrait le 2014-05-28]

## Description

### 1. DOMAINE TECHNIQUE

Le domaine de l'invention est celui des références de temps, en particulier celui des micro-horloges atomiques à microcellule de vapeur alcaline utilisant le piégeage cohérent de population (CPT, pour « cohérent population trapping » en anglais).

Ce type de micro-horloge atomique (dite « micro-horloge atomique CPT ») est décrit, par exemple, dans les articles suivants :
- S.Knappe et al. « A microfabricated atomic clock », Appl.Phys. Lett., vol. 85, no. 9, pp. 1460-1462, 2004 ;
- Boudot et al « High-Performance Frequency Stability Compact CPT Clock Based on a Cs-Ne Microcell » IEEE UFFC, vol59, n11, nov2012 ;
- J. Vanier, « Atomic docks based on cohérent population trapping: A review », Appl. Phys. B, vol. 81, no. 4, pp. 421-442, 2005.

Le signal de sortie d'une telle micro-horloge atomique est un signal électrique oscillant à une fréquence stable. Par stable, on entend un écart type d'Allan d'environ 10 ¹⁰-10⁻¹¹ pour des durées d'intégration d'une seconde et de 10-10-10-12 après une journée d'intégration.

Plus précisément, l'invention concerne une micro-horloge atomique CPT du type fonctionnant en régime impulsionnel (aussi appelée « micro-horloge atomique CPT à interrogation Ramsey »).

### 2. ARRIÈRE-PLAN TECHNOLOGIQUE

Les micro-horloges atomiques CPT fonctionnant en régime impulsionnel permettent une amélioration des performances par rapport aux micro-horloges atomiques CPT fonctionnant en régime continu.

Une architecture de micro-horloge atomique CPT fonctionnant en régime impulsionnel a déjà été démontrée et décrite dans l'article suivant : Abdel Hafiz et al., « Symmetric autobalanced Ramsey interrogation for high-performance coherentpopulation-trapping vapor-cell atomic clock », APL 112 244102 2018.

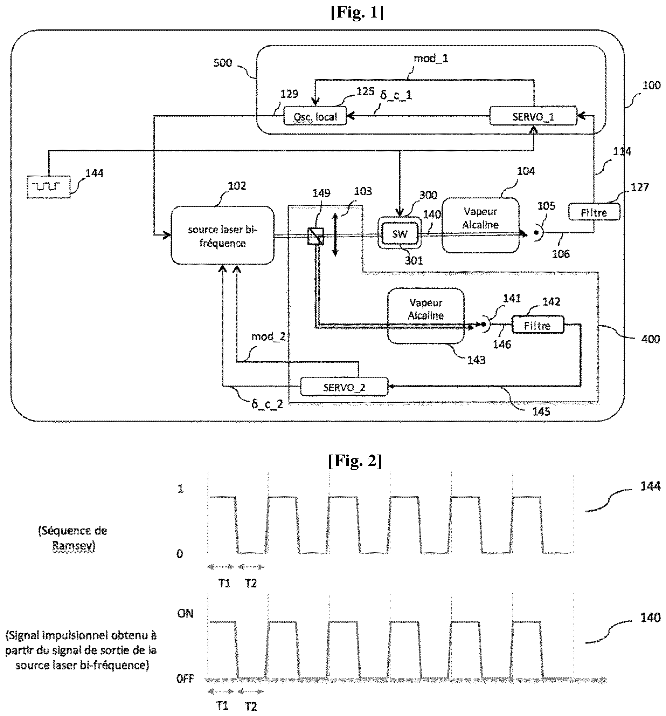

Comme illustré sur la **figure 1**, une micro-horloge atomique CPT 100 fonctionnant en régime impulsionnel comprend, selon cette technique connue :
- un oscillateur local 125 possédant une fréquence micro-onde ;
- une source laser bi-fréquence 102 recevant un signal de sortie 129 de l'oscillateur local 125 et possédant une fréquence optique. L'écart de fréquence entre les composantes spectrales du signal de sortie (faisceau laser) de la source laser bi-fréquence 102 est égal à la fréquence de l'oscillateur local 125 ;
- des moyens 300 configurés pour rendre impulsionnel le faisceau laser de la source laser bi-fréquence 102, en fonction d'une séquence d'interrogation de type Ramsey 144 (aussi appelée « séquence de Ramsey ») comprenant des impulsions d'une durée T1 séparées par des intervalles d'une durée T2. Plus précisément, les moyens 300 comprennent un interrupteur optique 301, placé entre la source laser bi-fréquence 102 et un élément optique de mise en forme 103, et qui est commandé par la séquence d'interrogation 144. La **figure 2** illustre la séquence de Ramsey 144 et le signal (faisceau laser) impulsionnel 140 obtenu en sortie de l'interrupteur optique 301, à partir du signal de sortie (faisceau laser) de la source laser bi-fréquence ;
- une microcellule de vapeur alcaline 104 recevant (via l'élément optique de mise en forme 103) le faisceau laser impulsionnel 140 et utilisant le piégeage cohérent de population. Une fois sorti de la microcellule de vapeur alcaline 104, le faisceau laser impulsionnel porte, sur son intensité lumineuse, une information de comparaison entre la fréquence micro-onde de l'oscillateur local 125 et une consigne de fréquence micro-onde. Cette consigne de fréquence micro-onde est la fréquence de résonance de la structure hyperfine des atomes de la vapeur alcaline de la microcellule 104 ;
- une photodiode 105 recevant un signal de sortie de la microcellule de vapeur alcaline 104. La photodiode 105 transforme l'intensité lumineuse impulsionnelle en un signal électrique 106 qui porte également l'information de comparaison entre la fréquence micro-onde de l'oscillateur local 125 et la consigne de fréquence micro-onde ;
- une boucle d'asservissement en fréquence micro-onde 500, recevant un signal 114 (résultant du filtrage du signal de sortie 106 de la photodiode 105 par un premier filtre 127) et configurée pour asservir la fréquence micro-onde de l'oscillateur local 125 à la consigne de fréquence micro-onde (fréquence de résonance de la structure hyperfine des atomes de la vapeur alcaline de la microcellule 104) ; et
- une boucle d'asservissement en fréquence optique 400, configurée pour asservir la fréquence optique de la source laser bi-fréquence 102 à une consigne de fréquence optique.

Plus précisément, la boucle d'asservissement en fréquence micro-onde 500 comprend un bloc de contrôle impulsionnel SERVO_1 qui génère et fournit un premier signal de correction δ_c_1 à l'oscillateur local 125, afin d'en asservir la fréquence micro-onde. En d'autres termes, l'interprétation du signal 114 par le bloc de contrôle impulsionnel SERVO_1 génère un signal d'erreur (signal de comparaison) δ_e_1, qui est négatif ou positif en fonction du résultat de la comparaison précitée. En fonction du signal d'erreur δ_e_1, le bloc de contrôle impulsionnel SERVO_1 génère un signal de correction (signal de rétroaction) δ_c_1 agissant sur la fréquence micro-onde de l'oscillateur local 125. L'élément SERVO_1 est donc un élément de contrôle et de régulation dont l'objectif est de rétroagir sur la fréquence micro-onde de l'oscillateur local 125 afin de minimiser sa différence avec la fréquence de résonnance micro-onde de la vapeur alcaline de la microcellule 104.

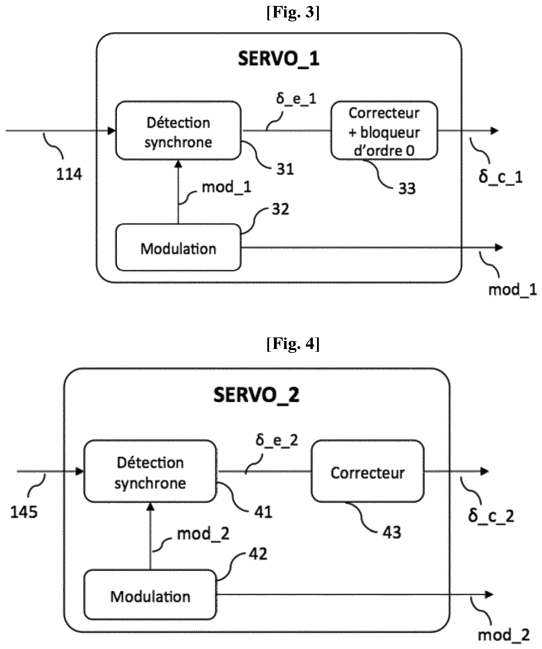

Dans une implémentation particulière illustrée sur la **figure 3**, le bloc de contrôle impulsionnel SERVO_1 comprend :
- un bloc de modulation 32 générant un signal de modulation mod_1 utilisé d'une part par l'oscillateur local 125 pour moduler son signal de sortie, et d'autre part par un bloc de détection synchrone 31 présenté ci-dessous (pour réaliser des étapes de démodulation internes au bloc de détection synchrone 31 qui aboutiront au filtrage puis à l'extraction d'un signal d'erreur δ_e_1) ;
- le bloc de détection synchrone 31 effectuant une démodulation du signal 114 sortant du filtre 127 (en aval de la photodiode 105), en fonction du signal de modulation mod_1, et générant un signal d'erreur δ_e_1. En d'autres termes, le bloc de détection synchrone 31 permet d'extraire un signal d'erreur δ_e_1 du signal 114 ; et
- un bloc de correction/blocage 33 (avec bloqueur d'ordre 0) recevant le signal d'erreur δ_e_1 et générant le signal de correction δ_c_1 (dont l'application sur l'oscillateur local 125 a pour objectif de minimiser le signal d'erreur δ_e_1).

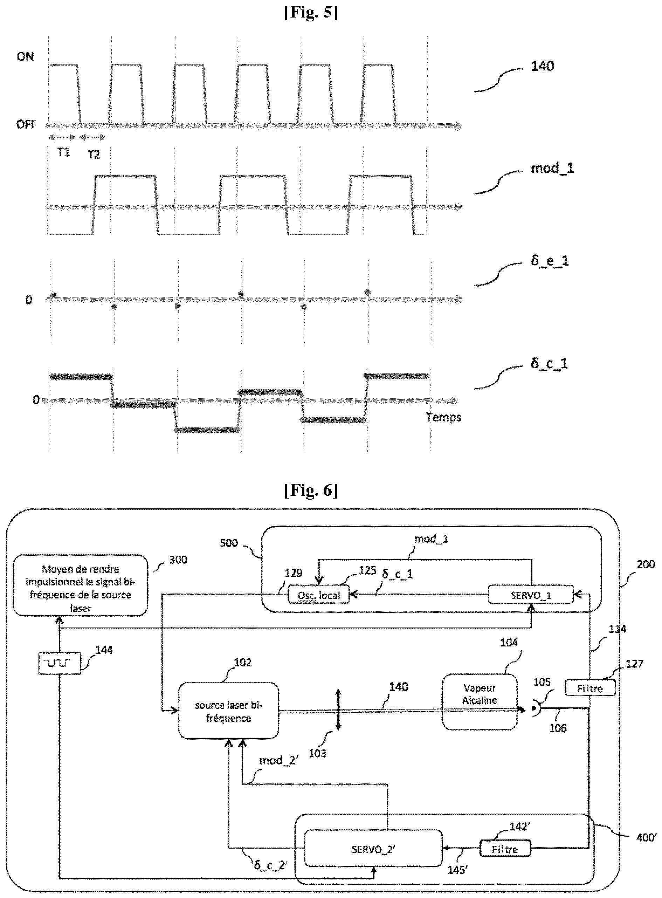

La **figure 5** illustre le fonctionnement du bloc de contrôle impulsionnel SERVO_1 de la figure 3, en présentant des chronogrammes du signal référencé 140 sur les figures 1 et 2, ainsi que des signaux référencés mod_1, δ_e_1 et δ_c_1 sur la figure 3. Ainsi, dans le cas d'une horloge atomique CPT fonctionnant en régime impulsionnel, le bloc de contrôle impulsionnel SERVO_1 vient échantillonner, à la fréquence de la séquence de Ramsey 144, le signal 114 issu (via le filtre 127) de la photodiode 105. Etant donné que la fréquence de modulation du signal de modulation mod_1 est typiquement deux fois plus basse que la fréquence (1/(T1+T2)) de la séquence de Ramsey, l'échantillonnage à la fréquence de la séquence de Ramsey permet de générer une valeur du signal d'erreur δ_e_1 pour chaque état du signal de modulation mod_1. De manière traditionnelle, une correction est calculée et un système de type bloqueur d'ordre 0 est utilisé pour générer le signal de correction δ_c_1 et le rendre continu. A chaque nouvelle valeur du signal d'erreur δ_e_1, une nouvelle valeur du signal de correction est générée, puis maintenue jusqu'à disponibilité d'une nouvelle valeur du signal d'erreur. La boucle d'asservissement de fréquence micro-onde ainsi réalisée a une bande passante limitée par la fréquence de la séquence de Ramsey.

La boucle d'asservissement en fréquence optique 400 comprend quant à elle :
- un séparateur 149, placé entre la source laser bi-fréquence 102 et l'interrupteur optique 301, permettant de dériver une partie du faisceau lumineux de la source laser bi-fréquence vers une deuxième microcellule de vapeur alcaline 143 ;
- la deuxième microcellule de vapeur alcaline 143. Une fois sorti de la deuxième microcellule de vapeur alcaline 143, le faisceau laser (non impulsionnel) porte, sur son intensité lumineuse, une information de comparaison entre la fréquence optique de la source laser bi-fréquence 102 et une consigne de fréquence optique. Cette consigne de fréquence optique est la fréquence optique des atomes de la vapeur alcaline de la deuxième microcellule 143 ;
- une deuxième photodiode 141, recevant un signal de sortie de la deuxième microcellule de vapeur alcaline 143. La deuxième photodiode 141 transforme l'intensité lumineuse en un signal électrique 146 qui porte également l'information de comparaison entre la fréquence optique de la source laser bi-fréquence 102 et la consigne de fréquence optique ;
- un deuxième filtre 142, recevant le signal de sortie 146 de la deuxième photodiode 105 et générant un signal 145 ;
- un bloc de contrôle non-impulsionnel SERVO_2, qui reçoit le signal 145 et qui génère et fournit un signal de correction δ_c_2 à la source laser bi-fréquence 102, afin d'en asservir la fréquence optique. Le bloc de contrôle SERVO_2 fonctionne sans discontinuité.

Dans une implémentation particulière illustrée sur la **figure 4**, le bloc de contrôle impulsionnel SERVO_2 comprend :
- un bloc de modulation 42 générant un signal de modulation mod_2 utilisé par la source laser bi-fréquence 102 pour moduler son signal de sortie ;
- un bloc de détection synchrone 41 effectuant une démodulation du signal 145 sortant du deuxième filtre 142 (en aval de la deuxième photodiode 141), en fonction du signal de modulation mod_2, et générant un signal d'erreur δ_e_2 ; et
- un bloc de correction 43 recevant le signal d'erreur δ_e_2 et générant le signal de correction δ_c_2.

Un inconvénient de cette technique connue est qu'elle ne présente pas des caractéristiques optimales en termes d'encombrement et de coût, du fait que la boucle d'asservissement en fréquence optique 400 nécessite divers composants tels que le séparateur 149, la deuxième microcellule de vapeur alcaline 143 et la deuxième photodiode 141. En d'autres termes, cette technique connue vise à fournir une micro-horloge atomique présentant un compromis encombrement/coût/performance très orienté sur la performance, au détriment de l'encombrement et du coût.

Un autre inconvénient de cette technique connue est que l'interrupteur optique 301, permettant de rendre impulsionnel le signal de sortie de la source laser bi-fréquence 102, doit impérativement être placé entre le séparateur 149 et la microcellule de vapeur alcaline 104 pour que bloc de contrôle SERVO_2 fonctionne sans discontinuité et donc que la boucle d'asservissement en fréquence optique 400 génère sans discontinuité un signal de correction δ_c_2 optimal. En d'autres termes, il n'y a pas de liberté pour la mise en oeuvre des moyens 300 configurés pour rendre impulsionnel le signal de sortie de la source laser bi-fréquence 102.

Une autre horloge atomique CPT, qui possède les caractéristiques selon le préambule de la revendication 1 annexée, est divulguée par Warren et al: "Pulsed cohérent population trapping with repeated queries for producing single-peaked high contrast Ramsey interférence", Journal of Applied Physics, American Institute of Physics, US, vol. 123, no. 5, 6 février 2018, numéro de publication XP012226150.

Les inventeurs ont détecté un besoin pour une micro-horloge atomique CPT, fonctionnant en régime impulsionnel et présentant un nouveau compromis encombrement/coût/performance, orienté vers le bas coût et le faible encombrement, tout en dégradant le moins possible la performance.

### 3. OBJECTIFS

L'invention, dans au moins un mode de réalisation, a notamment pour objectif de pallier l'inconvénient précité de l'état de la technique.

Plus précisément, dans au moins un mode de réalisation de l'invention, un objectif est de fournir une micro-horloge atomique CPT fonctionnant en régime impulsionnel, qui permette de satisfaire le besoin décrit ci-dessus, à savoir offrir un nouveau compromis encombrement/coût/performance, orienté vers le bas coût et le faible encombrement, tout en dégradant le moins possible la performance.

Un autre objectif d'au moins un mode de réalisation de l'invention est de fournir une telle micro-horloge atomique CPT qui offre plus de liberté que la solution connue pour la mise en oeuvre des moyens 300 configurés pour rendre impulsionnel le signal de sortie de la source laser bi-fréquence 102.

Un autre objectif d'au moins un mode de réalisation de l'invention est de fournir une telle micro-horloge atomique CPT qui soit plus simple à fabriquer et mettre en oeuvre que celle de la solution connue discutée plus haut.

### 4. RÉSUMÉ

Dans un mode de réalisation particulier de l'invention, il est proposé une micro-horloge atomique du type fonctionnant en régime impulsionnel et comprenant :
- un oscillateur local possédant une fréquence micro-onde ;
- une source laser bi-fréquence recevant un signal de sortie de l'oscillateur local et possédant une fréquence optique ;
- des moyens configurés pour rendre impulsionnel un signal de sortie de la source laser bi-fréquence, en fonction d'une séquence d'interrogation de type Ramsey comprenant des impulsions d'une durée T1 séparées par des intervalles d'une durée T2 ;
- une microcellule de vapeur alcaline recevant le signal de sortie de la source laser bi-fréquence et utilisant le piégeage cohérent de population ;
- une photodiode recevant un signal de sortie de la microcellule de vapeur alcaline ;
- une boucle d'asservissement en fréquence micro-onde, recevant un signal de sortie de la photodiode et configurée pour asservir la fréquence micro-onde de l'oscillateur local à une consigne de fréquence micro-onde fonction de la microcellule de vapeur alcaline ; et
- une boucle d'asservissement en fréquence optique, configurée pour asservir la fréquence optique de la source laser bi-fréquence à une consigne de fréquence optique.

Selon la solution proposée, la boucle d'asservissement en fréquence optique comprend un bloc de contrôle impulsionnel recevant le signal de sortie de la photodiode et la séquence d'interrogation, et fournissant un signal de correction à la source laser bi-fréquence en étant configuré pour agir comme suit :
- pendant la durée T1, extraction du signal d'erreur à partir du signal de sortie de la photodiode et génération du signal de correction à partir du signal d'erreur ; et
- pendant la durée T2, forçage du signal d'erreur à zéro et génération du signal de correction par extrapolation.

Ainsi, la solution proposée propose une approche tout à fait nouvelle et inventive consistant à utiliser la même microcellule de vapeur alcaline pour la boucle d'asservissement en fréquence micro-onde et pour la boucle d'asservissement en fréquence optique. Contrairement à la solution de Abdel Hafiz et al, discutée plus haut, la solution proposée comporte moins de composants pour réaliser la boucle d'asservissement en fréquence optique (pas de séparateur, pas de deuxième microcellule de vapeur alcaline et pas deuxième photodiode). Par ailleurs, dans la boucle d'asservissement en fréquence optique de la solution proposée, le bloc de contrôle est impulsionnel et donc de nature différente du bloc de contrôle (non impulsionnel) compris dans la boucle d'asservissement en fréquence optique de la solution connue. Ceci permet d'obtenir une micro-horloge atomique CPT fonctionnant en régime impulsionnel et offrant le nouveau compromis encombrement/coût/performance souhaité, c'est-à-dire orienté vers le bas coût et le faible encombrement, tout en dégradant le moins possible la performance.

Un autre avantage est que la micro-horloge de la solution proposée est plus simple à fabriquer et à mettre en oeuvre que celle de la solution connue.

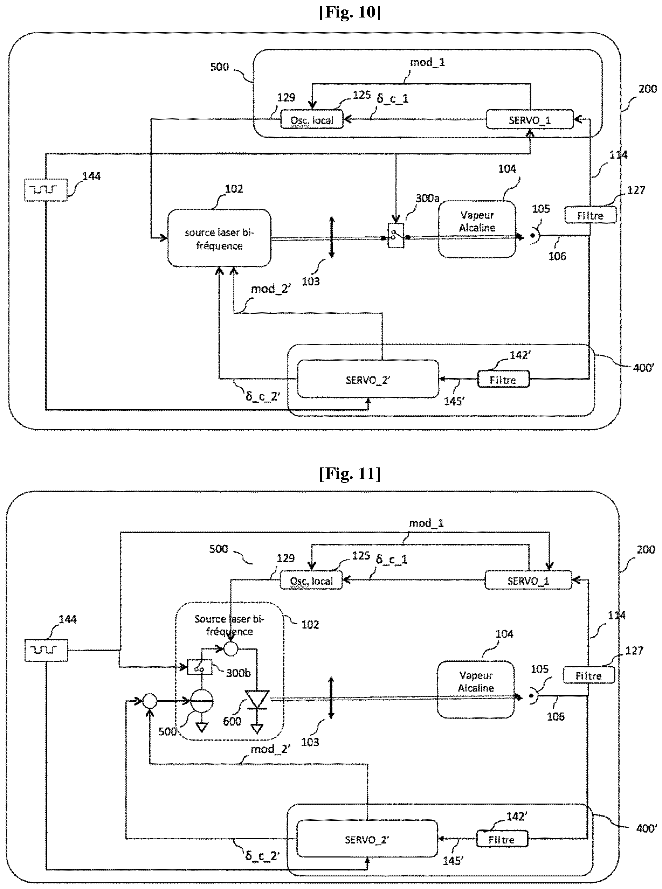

Encore un autre avantage est que la micro-horloge de la solution proposée offre plus de liberté que la solution connue pour la mise en oeuvre des moyens 300 configurés pour rendre impulsionnel le signal de sortie de la source laser bi-fréquence. En effet, comme détaillé par la suite (voir figures 10 à 12), diverses implémentations des moyens 300 sont envisageables puisque le bloc de contrôle SERVO_1 de la boucle d'asservissement en fréquence micro-onde et le bloc de contrôle SERVO_2 de la boucle d'asservissement en fréquence optique sont tous les deux des blocs de contrôle de type impulsionnel.

Selon une caractéristique particulière, la micro-horloge atomique comprend un bloc de modulation générant un signal de modulation utilisé par la source laser bi-fréquence pour moduler le signal de sortie de la source laser bi-fréquence). Le bloc de contrôle impulsionnel comprend : un bloc de détection synchrone effectuant une démodulation du signal de sortie de la photodiode en fonction du signal de modulation, et générant le signal d'erreur ; et un bloc de correction recevant le signal d'erreur et générant le signal de correction. Le signal de modulation et la séquence d'interrogation sont liés par une des relations suivantes : fₘ = K × 1/T1 et 1/T1 = K' × fₘ, avec fₘ la fréquence du signal de modulation, et K et K' appartenant aux entiers naturels.

Ainsi, le signal de modulation est synchrone avec les impulsions (de durée T1) de la séquence d'interrogation, ce qui permet une optimisation du calcul du signal d'erreur.

Selon une caractéristique particulière, le signal de modulation et la séquence d'interrogation sont liés par la relation : fₘ = K × 1/T1, avec : 1 ≤ K ≤ 30.

Ceci présente l'avantage d'avoir :
- une fréquence de modulation fₘ suffisamment haute pour pouvoir asservir la fréquence optique de la source laser bi-fréquence avec une bande de fréquences dans laquelle le bruit de la source laser bi-fréquence est faible, et
- une fréquence de modulation fₘ suffisamment basse pour éviter une électronique trop énergivore.

Selon une caractéristique particulière, le bloc de détection synchrone est configuré pour générer le signal d'erreur à R fois la fréquence fₘ du signal de modulation, avec R un nombre pair appartenant aux entiers naturels, et R≥2.

De cette façon, le signal de sortie de la photodiode est échantillonné à une fréquence R^{∗}fₘ, ce qui permet de générer à la même fréquence des valeurs successives du signal d'erreur. Du fait que R≥2, on dispose d'au moins une valeur du signal d'erreur pour chaque état du signal de modulation. Par ailleurs, le choix d'une valeur de R paire permet de faciliter le travail d'un calculateur compris dans le bloc de contrôle impulsionnel.

Selon une première implémentation particulière, le bloc de contrôle impulsionnel est configuré pour que, pendant la durée T2, la génération du signal de correction par extrapolation soit effectuée à l'aide d'un bloqueur d'ordre 0.

Dans cette première implémentation particulière, la mise en oeuvre de la fonction de blocage pendant chaque durée T2 est simple puisque basée sur un bloqueur d'ordre 0.

Selon une deuxième implémentation particulière, le bloc de contrôle impulsionnel est configuré pour que, pendant la durée T2, la génération du signal de correction par extrapolation soit effectuée à l'aide d'un bloqueur d'ordre N, avec N>0 ou d'une fonction de mise en forme du signal de correction.

Dans cette deuxième implémentation particulière, la mise en oeuvre de la fonction de blocage pendant chaque durée T2 est un peu moins simple (puisque basée sur un bloqueur d'ordre N>0 ou sur une fonction de mise en forme), mais ceci permet d'asservir la fréquence optique de manière plus continue. La fonction de mise en forme du signal de correction peut être une extrapolation qui présente l'avantage de bien compenser les dérives dont la fréquence de variation est inférieure à 1/T1. La fonction de mise en forme peut aussi se traduire par l'application de contraintes sur la dynamique de l'évolution du signal de correction (saturation du signal, saturation des dérivées d'ordre N du signal, ...).

### 5. LISTE DES FIGURES

D'autres caractéristiques et avantages de l'invention apparaîtront à la lecture de la description suivante, donnée à titre d'exemple indicatif et non limitatif, et des dessins annexés, dans lesquels :
**[****Fig. 1****]** La figure 1, déjà décrite plus haut en relation avec l'art antérieur, présente un schéma simplifié d'une micro-horloge atomique CPT fonctionnant en régime impulsionnel, selon la technique connue mentionnée plus haut ;
**[****Fig. 2****]** La figure 2, déjà décrite plus haut en relation avec l'art antérieur, illustre comment la séquence de Ramsey permet de rendre impulsionnel le signal de sortie de la source laser bi-fréquence apparaissant sur la figure 1 ;
**[****Fig. 3****]** La figure 3, déjà décrite plus haut en relation avec l'art antérieur, présente un schéma-bloc d'une implémentation particulière du bloc de contrôle impulsionnel SERVO_1 apparaissant sur la figure 1 ;
**[****Fig. 4****]** La figure 4, déjà décrite plus haut en relation avec l'art antérieur, présente un schéma-bloc d'une implémentation particulière du bloc de contrôle impulsionnel SERVO_2 apparaissant sur la figure 1 ;
**[****Fig. 5****]** La figure 5, déjà décrite plus haut en relation avec l'art antérieur, illustre le fonctionnement du bloc de contrôle impulsionnel SERVO_1 de la figure 3, en présentant des chronogrammes du signal référencé 140 sur les figures 1 et 2, ainsi que des signaux référencés mod_1, δ_e_1 et δ_c_1 sur la figure 3 ;
**[****Fig. 6****]** La figure 6 présente un schéma simplifié d'une micro-horloge atomique CPT fonctionnant en régime impulsionnel, selon un mode de réalisation particulier de l'invention ;
**[****Fig. 7****]** La figure 7 présente un schéma-bloc d'une implémentation particulière du bloc de contrôle impulsionnel SERVO_2' apparaissant sur la figure 6 ;
**[****Fig. 8****]** La figure 8 présente un exemple de réalisation du bloc de contrôle impulsionnel SERVO_2' de la figure 7 ;
**[****Fig. 9****]** La figure 9 illustre le fonctionnement du bloc de contrôle impulsionnel SERVO_2' de la figure 8, en présentant des chronogrammes du signal référencé 140 sur la figure 6, ainsi que des signaux référencés mod_2', δ_e_2' et δ_c_2' sur la figure 8 ;
**[****Fig. 10****]** La figure 10 illustre une première manière de réaliser les moyens référencés 300 sur la figure 6 (moyens de rendre impulsionnel le signal bi-fréquence de la source laser) ;
**[****Fig. 11****]** La figure 11 illustre une deuxième manière de réaliser les moyens référencés 300 sur la figure 6 ; et
**[****Fig. 12****]** La figure 12 illustre une troisième manière de réaliser les moyens référencés 300 sur la figure 6.

### 6. DESCRIPTION DÉTAILLÉE

Sur toutes les figures du présent document, les éléments identiques sont désignés par une même référence numérique.

On présente maintenant, en relation avec **figure 6****,** une micro-horloge atomique 200, de type CPT 200 et fonctionnant en régime impulsionnel, selon un mode de réalisation particulier de l'invention.

Ce mode de réalisation se distingue de la solution connue de la figure 1 en ce que la boucle d'asservissement en fréquence optique (400' , figure 6) n'est pas réalisée de la même manière que celle (400, figure 1) de la solution connue :
- elle ne comprend pas les éléments suivants : le séparateur 149, la deuxième microcellule de vapeur alcaline 143 et la deuxième photodiode 141 ;
- le filtre 142 est remplacé par un filtre 142' qui reçoit le signal de sortie 106 de la photodiode 105 et génère un signal 145' ; et
- le bloc de contrôle non-impulsionnel SERVO_2 est remplacé par un bloc de contrôle impulsionnel SERVO_2' qui reçoit le signal 145' et la séquence d'interrogation 144, et fournit un signal de correction δ_c_2' à la source laser bi-fréquence 102, afin d'en asservir la fréquence optique.

Les autres éléments sont identiques à ceux de la figure 1 (ils ne sont donc pas décrits à nouveau).

Le bloc de contrôle impulsionnel SERVO_2' est configuré pour agir comme suit :
- pendant la durée T1, extraction d'un signal d'erreur δ_e_2' à partir du signal 145' (lui-même issu, via le filtre 142', du signal de sortie 106 de la photodiode 105) et génération du signal de correction δ_c_2' à partir du signal d'erreur δ_e_2' ; et
- pendant la durée T2, forçage du signal d'erreur δ_e_2' à zéro et génération du signal de correction δ_c_2' par extrapolation (toute technique d'extrapolation peut être utilisée, notamment mais non exclusivement basée sur un bloqueur d'ordre n, avec n≥0, ou une fonction de mise en forme du signal de correction, comme détaillé plus bas).

Ainsi, avec la solution proposée, une seule cellule de vapeur alcaline 104 permet d'asservir à la fois la fréquence micro-onde de l'oscillateur local 125 et la fréquence optique de la source laser bi-fréquence 102, dans le mode de fonctionnement impulsionnel. On utilise astucieusement le fait que, pendant la durée T1, le faisceau laser impulsionnel en sortie de la microcellule de vapeur alcaline 104 porte à la fois : l'information de comparaison entre la fréquence micro-onde de l'oscillateur local 125 et la consigne de fréquence micro-onde, et l'information de comparaison entre la fréquence optique de la source laser bi-fréquence 102 et la consigne de fréquence optique.

Un avantage associé est une réduction du coût et de l'encombrement de la micro-horloge atomique 200 (pas de séparateur 149, de deuxième microcellule de vapeur alcaline 143 et de deuxième photodiode 141).

En outre, et comme détaillé par la suite en relation avec les figures 10 à 12, la solution proposée permet une plus grande liberté pour réaliser les moyens 300 de rendre impulsionnel le signal bi-fréquence de la source laser 102, puisque le bloc de contrôle SERVO_2' est de type impulsionnel (voir présentation détaillée ci-après).

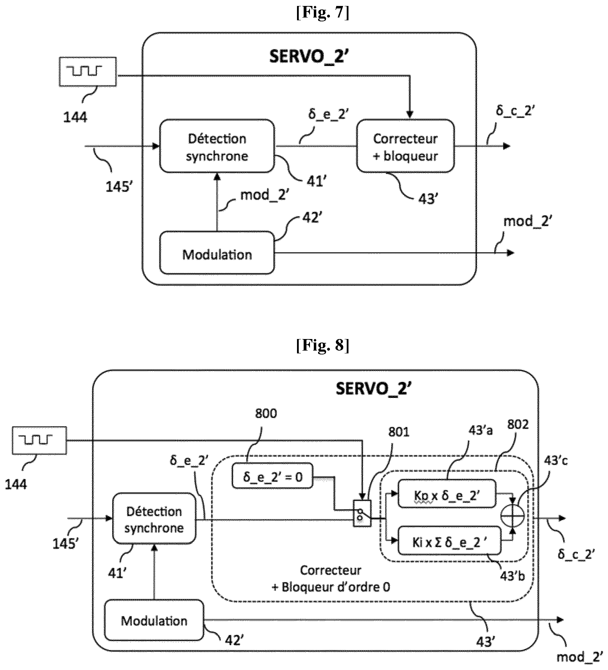

Dans une implémentation particulière illustrée sur la **figure 7**, le bloc de contrôle impulsionnel SERVO_2' comprend :
- un bloc de modulation 42' générant un signal de modulation mod_2' utilisé d'une part par l'oscillateur local 125 pour moduler son signal de sortie, et d'autre part par un bloc de détection synchrone 41' présenté ci-dessous (pour réaliser des étapes de démodulation internes au bloc de détection synchrone 41' qui aboutiront au filtrage puis à l'extraction d'un signal d'erreur δ_e_2') ;
- le bloc de détection synchrone 41' effectuant une démodulation du signal 145' sortant du filtre 142' (en aval de la photodiode 105), en fonction du signal de modulation mod_2', et générant un signal d'erreur δ_e_2'. En d'autres termes, le bloc de détection synchrone 41' permet d'extraire un signal d'erreur δ_e_2' du signal 1145' ; et
- un bloc de correction/blocage 43' (avec bloqueur d'ordre n, avec n≥0) recevant le signal d'erreur δ_e_2' et générant le signal de correction δ_c_2' (dont l'application sur la source laser bi-fréquence 102 a pour objectif de minimiser le signal d'erreur δ_e_2').

On rappelle qu'il existe plusieurs sortes de bloqueurs. Leur principe est de « recréer » du signal entre des valeurs discrètes fournies en entrée. Le plus simple est le bloqueur d'ordre 0 dont la sortie garde la même valeur jusqu'à l'arrivée d'une nouvelle valeur en entrée. L'ordre du bloqueur représente la complexité de la section de courbe située entre deux valeurs : pour un ordre 0, la représentation de la sortie donnera un histogramme en barres ; pour un ordre 1, on aura des segments reliant directement deux valeurs successives, soit une interpolation linéaire basique ; pour un ordre 2, on obtiendra une parabole entre deux valeurs ; pour un ordre n, on obtiendra une courbe d'ordre n entre deux valeurs successives.

On comprend à la lumière de ce qui précède que le bloc de contrôle impulsionnel SERVO_2' est différent du bloc de contrôle non-impulsionnel SERVO_2 de la solution connue, et ne peut donc pas être simplement remplacé celui-ci. En effet, à la différence du bloc SERVO_2, le bloc de contrôle impulsionnel SERVO_2' reçoit un signal 145' issu de la même microcellule de vapeur alcaline 104 que le signal 114 reçu par le bloc de contrôle impulsionnel SERVO_1. Le signal 145' est constamment interrompu (il n'est utilisable que pour les durées T1 des impulsions) et porte une première information de comparaison (entre la fréquence optique de la source laser bi-fréquence 102 et la consigne de fréquence optique) générée au sein du même canal de propagation (à savoir la microcellule de vapeur alcaline 104) qu'une deuxième information de comparaison (entre la fréquence micro-onde de l'oscillateur local 125 et la consigne de fréquence micro-onde) portée par le signal 114 utilisé par le bloc de contrôle SERVO_1.

En d'autres termes, le signal de sortie 106 de la photodiode 105 porte les première et deuxième informations de comparaison, mais la première est destinée au bloc de contrôle impulsionnel SERVO_2' tandis que la deuxième est destinée au bloc de contrôle impulsionnel SERVO_1. Il convient donc de séparer (orthogonaliser) les première et deuxième informations de comparaison. Ceci est effectué par multiplexage temporel ou fréquentiel. Dans le cas d'un fonctionnement avec multiplexage fréquentiel, une solution de filtrage est mise en place. C'est le cas dans l'implémentation particulière de la figure 6, avec les filtres 127 et 142' qui permettent respectivement d'obtenir les signaux 114 et 145', à partir du même signal de sortie 106 de la photodiode 105.

En outre, dans un mode de réalisation particulier, afin d'optimiser le calcul du signal d'erreur δ_e_2', le signal de modulation mod_2' et la séquence d'interrogation 144 sont liés par une des relations suivantes : fₘ = K × 1/T1 et 1/T1 = K' × fₘ, avec fₘ la fréquence du signal de modulation mod_2', et K et K' appartenant aux entiers naturels. En d'autres termes, le signal de modulation mod_2' est synchrone avec les impulsions (de durée T1) de la séquence d'interrogation 144.

Encore plus particulièrement, dans le cas où le signal de modulation mod_2' et la séquence d'interrogation 144 sont liés par la relation : fₘ = K × 1/T1, on choisit K tel que : 1 ≤ K ≤ 30. Ceci présente l'avantage d'avoir une fréquence de modulation fₘ suffisamment haute pour pouvoir asservir la fréquence optique de la source laser bi-fréquence avec une bande de fréquences dans laquelle le bruit de la source laser bi-fréquence est faible, et une fréquence de modulation fₘ suffisamment basse pour éviter une électronique trop énergivore. Par exemple, on prend : K=3 et (1/T1)=3kHz, ce qui conduit à : fₘ=9kHz.

Le bloc de contrôle impulsionnel SERVO_1 fonctionne également différemment du bloc de contrôle impulsionnel SERVO-2' puisque le bloc SERVO_1 fonctionne avec : 1/(T1+T2) = K" × fₘ₁, avec K" appartenant aux entiers naturels (K"=2 dans l'exemple de la figure 5) et fₘ₁ la fréquence du signal de modulation mod_1. En outre, le bloc SERVO_1 nécessite le caractère impulsionnel de la source (pas d'information d'erreur possible si pas de séquence d'interrogation de type Ramsey).

Au contraire, le bloc SERVO_2' subit le caractère impulsionnel de la source et n'a accès à une information utile que pendant T1. En effet, comme déjà mentionné plus haut, le signal 145' entrant dans le bloc de contrôle impulsionnel SERVO_2' est constamment interrompu. En effet, l'information de comparaison entre la fréquence optique du laser et la fréquence optique de l'atome n'est disponible que lorsque la bi-fréquence est allumée, c'est-à-dire pendant la durée T1. Pendant la durée T2, la bi-fréquence est éteinte et l'information de comparaison n'est pas disponible. La solution proposée permet de faire fonctionner le bloc de contrôle impulsionnel SERVO_2' dans ce mode interrompu.

Dans un mode de réalisation particulier, le bloc de détection synchrone 41' (voir figure 7) est configuré pour générer le signal d'erreur δ_e_2' à R fois la fréquence fₘ du signal de modulation mod_2', avec R un nombre pair appartenant aux entiers naturels et R≥2. De cette façon, le signal de sortie 106 de la photodiode 105 est échantillonné à une fréquence R^{∗}fₘ, ce qui permet de générer à la même fréquence des valeurs successives du signal d'erreur δ_e_2'. Du fait que R≥2, on dispose d'au moins une valeur du signal d'erreur pour chaque état du signal de modulation. Le choix d'une valeur de R paire permet de faciliter le travail d'un calculateur compris dans le bloc de contrôle impulsionnel SERVO_2' (on possède ainsi un nombre identique d'échantillons par état de modulation, ce qui facilite le calcul du bloc de détection synchrone et la synchronisation générale des signaux). Les valeurs R=2 et R=4 correspondent à un bon compromis de précision/énergie consommée. En effet, augmenter la valeur de R augmente la précision de la mesure (robustesse au bruit) mais réclame plus de rapidité (calcul et échantillonnage).

Le signal de correction est généré par le bloc de correction/blocage 43'. Lorsque l'information de comparaison entre la fréquence optique du laser et la fréquence optique de l'atome est disponible (c'est-à-dire pendant T1), le signal de correction est généré de manière classique. Lorsqu'elle n'est pas disponible (c'est-à-dire pendant T2), le signal de correction est généré par la fonction de blocage d'ordre n, avec n≥0, ou une fonction de mise en forme du signal de correction.

La **figure 8** présente un exemple de réalisation du bloc de contrôle impulsionnel SERVO_2' de la figure 7, dans le cas où le bloc de correction/blocage 43' intègre un bloqueur d'ordre 0. En d'autres termes, le bloc de contrôle impulsionnel SERVO_2' est dans ce cas configuré pour que, pendant la durée T2, la génération du signal de correction δ_c_2' par extrapolation soit effectuée à l'aide d'un bloqueur d'ordre 0.

Dans cet exemple de réalisation, le bloc de correction/blocage 43' comprend :
- un correcteur 800 de type « Proportionnel Intégral (PI) », comprenant une première branche 43'a réalisant une fonction proportionnelle (Kp × δ_e_2'), une deuxième branche 43'b réalisant une fonction intégrale (Ki × Σδ_e_2') et un élément sommateur 43'c qui additionne les résultats de première et deuxième branches pour générer le signal de correction δ_c_2' ; et
- un interrupteur (fonction interruptrice) 801, recevant d'une part le signal d'erreur δ_e_2' généré par le bloc de détection synchrone 41' et d'autre part un signal d'erreur nul 800 (c'est-à-dire δ_e_2'=0), et commandé par la séquence d'interrogation 144 comme suit : pendant la durée T1, fourniture au correcteur 800 du signal d'erreur δ_e_2' généré par le bloc de détection synchrone 41', et pendant la durée T2, fourniture au correcteur 800 du signal d'erreur nul 800.

Ainsi, pendant la durée T1 (c'est-à-dire pendant que le signal 145' porte l'information de comparaison entre la fréquence optique de la source laser bi-fréquence 102 et la consigne de fréquence optique), on utilise le signal d'erreur fourni par le bloc de détection synchrone 41' pour calculer une correction de type « PI ». En revanche, pendant la durée T2 (c'est-à-dire pendant que le signal 145' ne porte pas l'information de comparaison entre la fréquence optique de la source laser bi-fréquence 102 et la consigne de fréquence optique), on utilise le signal d'erreur nul pour extrapoler une correction (la première branche 43'a fournit un résultat nul (Kp × δ_e_2'=0), mais la deuxième branche 43'b fournit un résultat non nul (Ki × Σδ_e_2'≠0) car elle garde la mémoire des erreurs calculées pendant la durée T1.

Cet exemple de réalisation à l'avantage de n'ajouter qu'une légère modification (ajout de la fonction interruptrice 801) à la structure classique de correcteur 800 de type « PI ».

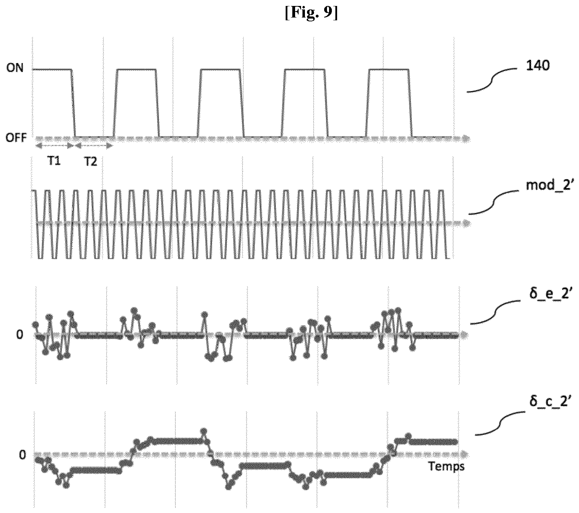

La **figure 9** illustre le fonctionnement du bloc de contrôle impulsionnel SERVO_2' de la figure 8, en présentant des chronogrammes du signal 140 (voir figure 6), ainsi que des signaux mod_2', δ_e_2' et δ_c_2' (voir figure 8).

Ainsi, dans le cas d'un correcteur « PI », la solution proposée consiste à :
- annuler l'action proportionnelle pendant la durée T2 (c'est-à-dire entre deux impulsions de la séquence d'interrogation 144). Par exemple, ceci est fait en mettant en oeuvre une commutation analogique ou une annulation algorithmique du calcul de l'action proportionnelle ; et
- conserver l'action intégrale constante pendant la durée T2. Par exemple, ceci est fait en conservant la charge d'un élément capacitif d'un filtre ou en conservant constante la valeur d'un accumulateur numérique.

Dans une première variante de réalisation du bloc de contrôle impulsionnel SERVO_2', on remplace le correcteur 800 de type « Proportionnel Intégral (PI) » par un correcteur de type « Proportionnel Intégral Dérivé (PID) ». Dans ce cas, la solution proposée consiste à :
- annuler l'action proportionnelle pendant la durée T2 (c'est-à-dire entre deux impulsions de la séquence d'interrogation 144). Par exemple, ceci est fait en mettant en oeuvre une commutation analogique ou une annulation algorithmique du calcul de l'action proportionnelle ; et
- conserver l'action intégrale constante pendant la durée T2. Par exemple, ceci est fait en conservant la charge d'un élément capacitif d'un filtre ou en conservant constante la valeur d'un accumulateur numérique ;
- ajuster l'action dérivée calculée au départ d'une impulsion (de durée T1). Par exemple, ceci est fait en annulant la valeur initiale de l'action dérivée lors d'une nouvelle impulsion, ou en pondérant (« coefficientant ») cette action par la durée T2 entre les deux impulsions.

Dans une deuxième variante de réalisation du bloc de contrôle impulsionnel SERVO_2', le bloc de correction/blocage 43' intègre un bloqueur d'ordre N, avec n>0, ou une fonction de mise en forme du signal de correction. En d'autres termes, le bloc de contrôle impulsionnel SERVO_2' est dans ce cas configuré pour que, pendant la durée T2, la génération du signal de correction δ_c_2' par extrapolation soit effectuée à l'aide d'un bloqueur d'ordre N ou d'une fonction de mise en forme du signal de correction. Ceci permet d'asservir la fréquence optique de manière plus continue. La fonction de mise en forme du signal peut être une extrapolation qui présente l'avantage de bien compenser les dérives dont la fréquence de variation est inférieure à 1/T1. La mise en forme peut aussi se traduire par l'application de contraintes sur la dynamique de l'évolution du signal de correction (saturation du signal de correction, saturation des dérivées d'ordre N du signal de correction).

Comme mentionné plus haut, la solution proposée permet, contrairement à la solution connue, d'envisager diverses manières de réaliser les moyens 300 de rendre impulsionnel le signal bi-fréquence de la source laser 102. Sans que cela soit exhaustif, diverses implémentations sont présentées ci-dessous.
La **figure 10** illustre une première manière de réaliser les moyens 300. Elle consiste à intercaler un interrupteur optique 300a entre la source de laser bi-fréquence 102 et la microcellule de vapeur alcaline 104. Cet interrupteur optique 300a est commandé en ouverture et fermeture par la séquence de Ramsey 144.
La **figure 11** illustre une deuxième manière de réaliser les moyens 300. Elle consiste, au sein de la source de laser bi-fréquence 102, à intercaler un interrupteur électrique 300b sur la source de courant 500 qui alimente la diode laser 600. Cet interrupteur électrique 300b est commandé en ouverture et fermeture par la séquence de Ramsey 144.

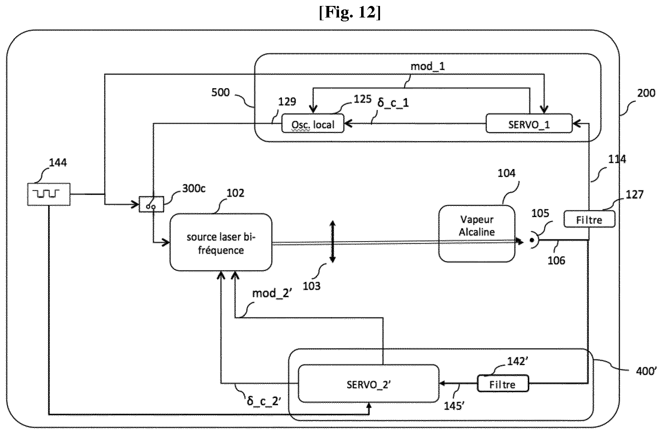

La **figure 12** illustre une troisième manière de réaliser les moyens 300. Elle consiste à intercaler un interrupteur électrique 300c sur le signal 129 issu de l'oscillateur local 125. Cet interrupteur électrique 300c est commandé en ouverture et fermeture par la séquence de Ramsey 144.

Une quatrième manière (non illustrée) consiste à interrompre le fonctionnement bi-fréquence de la source laser 102 en éteignant en son sein l'élément qui la rend bi-fréquence. Les interruptions sont commandées par la séquence de Ramsey 144. Un tel élément est décrit par exemple dans l'article suivant : « *Tunable dual-frequency laser source for cohérent population trapping césium atomic clock* », DOI : 10.1117/12.2309273.

## Revendications

1. Micro-horloge atomique (200) du type fonctionnant en régime impulsionnel et comprenant :
- un oscillateur local (125) possédant une fréquence micro-onde ;
- une source laser bi-fréquence (102) recevant un signal de sortie de l'oscillateur local (125) et possédant une fréquence optique ;
- des moyens (300) configurés pour rendre impulsionnel un signal de sortie de la source laser bi-fréquence (102), en fonction d'une séquence d'interrogation de type Ramsey (144) comprenant des impulsions d'une durée T1 séparées par des intervalles d'une durée T2 ;
- une microcellule de vapeur alcaline (104) recevant le signal de sortie de la source laser bi-fréquence (102) et utilisant le piégeage cohérent de population ;
- une photodiode (105) recevant un signal de sortie de la microcellule de vapeur alcaline (104) ;
- une boucle d'asservissement en fréquence micro-onde (500), recevant un signal de sortie de la photodiode (105) et configurée pour asservir la fréquence micro-onde de l'oscillateur local (125) à une consigne de fréquence micro-onde fonction de la microcellule de vapeur alcaline (104) ; et
- une boucle d'asservissement en fréquence optique (400'), configurée pour asservir la fréquence optique de la source laser bi-fréquence (102) à une consigne de fréquence optique ;
**caractérisée en ce que** la boucle d'asservissement en fréquence optique (400') comprend un bloc de contrôle impulsionnel (SERVO_2') recevant le signal de sortie de la photodiode (105) et la séquence d'interrogation (144), et fournissant un signal de correction (δ_c_2') à la source laser bi-fréquence (102) en étant configuré pour agir comme suit :
- pendant la durée T1, extraction d'un signal d'erreur (δ_e_2') à partir du signal de sortie de la photodiode (105) et génération du signal de correction (δ_c_2') à partir du signal d'erreur ; et
- pendant la durée T2, forçage du signal d'erreur (δ_e_2') à zéro et génération du signal de correction (δ_c_2') par extrapolation.

2. Micro-horloge atomique selon la revendication 1, **caractérisée en ce qu'**elle comprend un bloc de modulation (42') générant un signal de modulation (mod_2') utilisé par la source laser bi-fréquence (102) pour moduler le signal de sortie de la source laser bi-fréquence (102) ;
**en ce que** le bloc de contrôle impulsionnel (SERVO_2') comprend :
- un bloc de détection synchrone (41') effectuant une démodulation du signal de sortie de la photodiode (105) en fonction du signal de modulation (147'), et générant le signal d'erreur (δ_e_2') ; et
- un bloc de correction (43') recevant le signal d'erreur (δ_e_2') et générant le signal de correction (δ_c_2') ;
et **en ce que** le signal de modulation (mod_2') et la séquence d'interrogation (144) sont liés par une des relations suivantes : fₘ = K × 1/T1 et 1/T1 = K' × fₘ, avec fₘ la fréquence du signal de modulation (mod_2'), et K et K' appartenant aux entiers naturels.

3. Micro-horloge atomique selon la revendication 2, **caractérisée en ce que** le signal de modulation (mod_2') et la séquence d'interrogation (144) sont liés par la relation : fₘ = K × 1/T1, et **en ce que** : 1 ≤ K ≤ 30.

4. Micro-horloge atomique selon l'une quelconque des revendications 2 et 3, **caractérisée en ce que** le bloc de détection synchrone (41') est configuré pour générer le signal d'erreur (δ_e_2') à R fois la fréquence fₘ du signal de modulation, avec R un nombre pair appartenant aux entiers naturels, et R≥2.

5. Micro-horloge atomique selon l'une quelconque des revendications 1 à 4, **caractérisée en ce que** le bloc de contrôle impulsionnel (SERVO_2') est configuré pour que, pendant la durée T2, la génération du signal de correction (δ_c_2') par extrapolation soit effectuée à l'aide d'un bloqueur d'ordre 0.

6. Micro-horloge atomique selon l'une quelconque des revendications 1 à 4, **caractérisée en ce que** le bloc de contrôle impulsionnel (SERVO_2') est configuré pour que, pendant la durée T2, la génération du signal de correction (δ_c_2') par extrapolation soit effectuée à l'aide d'un bloqueur d'ordre N, avec N>0 ou d'une fonction de mise en forme du signal de correction.

## Patentansprüche

1. Miniatur-Atomuhr (200) vom Typ mit Pulsmodusbetrieb, die Folgendes umfasst:
- einen Lokaloszillator (125), der eine Mikrowellenfrequenz besitzt;
- eine Zweifrequenz-Laserquelle (102), die ein Ausgangssignal von dem Lokaloszillator (125) empfängt und eine optische Frequenz besitzt;
- Mittel (300), die dazu ausgestaltet sind, ein Ausgangssignal der Zweifrequenz-Laserquelle (102) in Abhängigkeit von einer Abfragefolge vom Typ Ramsey (144), die Pulse mit einer Dauer T1 umfasst, die von Intervallen mit einer Dauer T2 getrennt sind, zu einem Pulssignal zu machen;
- eine Alkalidampf-Mikrozelle (104), die das Ausgangssignal von der Zweifrequenz-Laserquelle (102) empfängt und Coherent Population Trapping verwendet;
- eine Fotodiode (105), die ein Ausgangssignal der Alkalidampf-Mikrozelle (104) empfängt;
- einen Mikrowellenfrequenz-Regelkreis (500), der ein Ausgangssignal der Fotodiode (105) empfängt und dazu ausgestaltet ist, die Mikrowellenfrequenz des Lokaloszillators (125) auf einen Mikrowellenfrequenz-Sollwert zu regeln, der von der Alkalidampf-Mikrozelle (104) abhängig ist; und
- einen Optische-Frequenz-Regelkreis (400'), der dazu ausgestaltet ist, die optische Frequenz der Zweifrequenz-Laserquelle (102) auf einen Optische-Frequenz-Sollwert zu regeln;
**dadurch gekennzeichnet, dass** der Optische-Frequenz-Regelkreis (400') einen Pulssteuerblock (SERVO_2') umfasst, der das Ausgangssignal der Fotodiode (105) und die Abfragefolge (144) empfängt und ein Korrektursignal (δ_c_2') an die Zweifrequenz-Laserquelle (102) liefert, indem er dazu ausgestaltet ist, wie folgt zu wirken:
- während der Dauer T1, Extrahieren eines Fehlersignals (δ_e_2') ausgehend von dem Ausgangssignal der Fotodiode (105) und Erzeugen des Korrektursignals (δ_c_2') ausgehend von dem Fehlersignal; und
- während der Dauer T2, Zwingen des Fehlersignals (δ_e_2') auf null und Erzeugen des Korrektursignals (δ_c_2') durch Extrapolation.

2. Miniatur-Atomuhr nach Anspruch 1, **dadurch gekennzeichnet, dass** sie einen Modulationsblock (42') umfasst, der ein Modulationssignal (mod_2') erzeugt, das durch die Zweifrequenz-Laserquelle (102) zum Modulieren des Ausgangssignals der Zweifrequenz-Laserquelle (102) verwendet wird;
**dadurch gekennzeichnet, dass** der Pulssteuerblock (SERVO_2') Folgendes umfasst:
- einen Synchrondetektionsblock (41'), der eine Demodulation des Ausgangssignals der Fotodiode (105) in Abhängigkeit von dem Modulationssignal (147') durchführt und das Fehlersignal (δ_e_2') erzeugt; und
- einen Korrekturblock (43'), der das Fehlersignal (δ_e_2') empfängt und das Korrektursignal (δ_c_2') erzeugt;
und dadurch, dass das Modulationssignal (mod_2') und die Abfragefolge (144) durch eine der folgenden Beziehungen verbunden sind: fₘ = K × 1/T1 und 1/T1 = K' × fₘ, wo fₘ die Frequenz des Modulationssignals (mod_2') ist und K und K' zu den natürlichen Zahlen gehören.

3. Miniatur-Atomuhr nach Anspruch 2, **dadurch gekennzeichnet, dass** das Modulationssignal (mod_2') und die Abfragefolge (144) durch die folgende Beziehung verbunden sind: fₘ =K × 1/T1, und dadurch, dass 1 ≤ K ≤ 30.

4. Miniatur-Atomuhr nach einem der Ansprüche 2 und 3, **dadurch gekennzeichnet, dass** der Synchrondetektionsblock (41') dazu ausgestaltet ist, das Fehlersignal (δ_e_2') mit R Mal die Frequenz fₘ des Modulationssignals zu erzeugen, wobei R eine gerade Zahl ist, die zu den natürlichen Zahlen gehört, und R ≥ 2.

5. Miniatur-Atomuhr nach einem der Ansprüche 1 bis 4, **dadurch gekennzeichnet, dass** der Pulssteuerblock (SERVO_2') so ausgestaltet ist, dass während der Dauer T2 die Erzeugung des Korrektursignals (δ_c_2') durch Extrapolation mittels eines Halters 0. Ordnung durchgeführt wird.

6. Miniatur-Atomuhr nach einem der Ansprüche 1 bis 4, **dadurch gekennzeichnet, dass** der Pulssteuerblock (SERVO_2') so ausgestaltet ist, dass während der Dauer T2 die Erzeugung des Korrektursignals (δ_c_2') durch Extrapolation mittels eines Halters N. Ordnung mit N>0 oder einer Formgebungsfunktion des Korrektursignals durchgeführt wird.

## Claims

1. A miniature atomic clock (200) with pulse mode operation, comprising:
- a local oscillator (125) having a microwave frequency;
- a dual-frequency laser source (102) receiving an output signal from the local oscillator (125) and having an optical frequency;
- means (300) configured to pulse an output signal from the dual-frequency laser source (102), according to a Ramsey-type interrogation sequence (144) comprising pulses with a period T1 separated by intervals with a period T2;
- an alkaline vapour microcell (104) receiving the output signal from the dual-frequency laser source (102) and using coherent population trapping;
- a photodiode (105) receiving an output signal from the alkaline vapour microcell (104);
- a feedback control loop (500) for controlling microwave frequency, receiving an output signal from the photodiode (105) and configured to servo-control the microwave frequency of the local oscillator (125) to a microwave frequency setpoint depending on the alkaline vapour microcell (104); and
- a feedback control loop (400') for controlling optical frequency, configured to servo-control the optical frequency of the dual-frequency laser source (102) to an optical frequency setpoint;
**characterised in that** the feedback control loop (400') for servo-controlling optical frequency comprises a pulse control block (SERVO_2') receiving the output signal from the photodiode (105) and the interrogation sequence (144), and providing a correction signal (δ_c_2') to the dual-frequency laser source (102) while being configured to act as follows:
- during the period T1, extracting an error signal (δ_e_2') from the output signal received from the photodiode (105) and generating the correction signal (δ_c_2') from the error signal; and
- during the period T2, resetting the error signal (δ_e_2') to zero and generating the correction signal (δ_c_2') by extrapolation.

2. Miniature atomic clock according to claim 1, **characterised in that** it comprises a modulation block (42') generating a modulation signal (mod_2') used by the dual-frequency laser source (102) to modulate the output signal from the dual-frequency laser source (102);
**in that** the pulse control block (SERVO_2') comprises:
- a synchronous detection block (41') demodulating the output signal received from the photodiode (105) according to the modulation signal (147'), and generating the error signal (δ_e_2'); and
- a correction block (43') receiving the error signal (δ_e_2') and generating the correction signal (δ_c_2');
and **in that** the modulation signal (mod_2') and the interrogation sequence (144) are related by one of the following relationships: fₘ = K × 1/T1 and 1/T1 = K' × fₘ, with fₘ the frequency of the modulation signal (mod_2'), and K and K' belonging to the natural integers.

3. Miniature atomic clock according to claim 2, **characterised in that** the modulation signal (mod_2') and the interrogation sequence (144) are related by the relationship: fₘ = K × 1/T1, and **in that**: 1 ≤ K ≤ 30.

4. Miniature atomic clock according to any one of claims 2 and 3, **characterised in that** the synchronous detection block (41') is configured to generate the error signal (δ_e_2') at R times the frequency fₘ of the modulation signal, with R an even number belonging to the natural integers, and R≥2.

5. Miniature atomic clock according to any one of claims 1 to 4, **characterised in that** the pulse control block (SERVO_2') is configured so that, during the period T2, the generation of the correction signal (δ_c_2') by extrapolation is carried out using a blocker of order 0.

6. Miniature atomic clock according to any one of claims 1 to 4, **characterised in that** the pulse control block (SERVO_2') is configured so that, during the period T2, the generation of the correction signal (δ_c_2') by extrapolation is carried out using a blocker of order N, with N>0 or a correction signal shaping function.
